(19) Europäisches Patentamt
European Patent Office
Office européen des brevets

(11) Veröffentlichungsnummer: **0 053 260**
**B1**

(12) # EUROPÄISCHE PATENTSCHRIFT

(45) Veröffentlichungstag der Patentschrift: **01.02.84**

(51) Int. Cl.³: **G 03 C 1/80,** G 03 C 1/94, G 03 F 7/02 // B41N1/06

(21) Anmeldenummer: **81108479.7**

(22) Anmeldetag: **19.10.81**

(54) **Lichtempfindliches Mehrschichtenmaterial und Verfahren zu seiner Herstellung.**

(30) Priorität **03.12.80 DE 3045549**

(43) Veröffentlichungstag der Anmeldung: **09.06.82 Patentblatt 82/23**

(45) Bekanntmachung des Hinweises auf die Patenterteilung: **01.02.84 Patentblatt 84/5**

(84) Benannte Vertragsstaaten: **BE CH DE FR GB IT LI NL**

(56) Entgegenhaltungen: **keine**

(73) Patentinhaber: **BASF Aktiengesellschaft, Carl-Bosch-Strasse 38, D-6700 Ludwigshafen (DE)**

(72) Erfinder: **Lenz, Werner, Dr., Heinrich-Baermann-Strasse 14, D-6702 Bad Duerkheim (DE)**
Erfinder: **Elis, German, Pankratiusstrasse 35, D-5010 Bergheim (DE)**
Erfinder: **Hoffmann, Gerhard, Dr., Pappelstrasse 22, D-6701 Otterstadt (DE)**
Erfinder: **Zuerger, Manfred, Holderlandstrasse 2, D-6920 Sinsheim (DE)**

**EP 0 053 260 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

# Lichtempfindliches Mehrschichtenmaterial und Verfahren zu seiner Herstellung

Die Erfindung betrifft lichtempfindliche Mehrschichtenmaterialien wie fotopolymere Reliefdruckplatten, die zwischen einem Trägerblech und einer Fotoinitiator enthaltenden lichtempfindlichen Monomer-Polymer-Schicht eine spezielle Haftschicht aufweisen.

Mehrschichtenmaterialien der vorgenannten Art sind an sich bekannt. Speziell bei lichtempfindlichen Monomer-Polymer-Schichten, die in unbelichtetem Zustand mit wäßrigen Lösungsmitteln auswaschbar sind, z. B. bei Schichten aus Polyvinylalkohol-Monomer-Mischungen, treten aber häufig Probleme bezüglich der Haftung zwischen der fotoinitiatorhaltigen Monomer-Polymer-Schicht und dem Stahl- oder Aluminium-Trägerblech auf. Manchmal treten sogar unmittelbar nach der Mehrschichtenplattenherstellung Ablösungen zwischen der unbelichteten Monomer-Polymer-Schicht und dem Trägermaterial auf oder es werden entsprechend niedrige Haftwerte im Zugprüfgerät gemessen. Oft treten stark schwankende Haftungen auf, die bei Verarbeitung der Platten zu Druckklischees zu teilweisen Reliefablösungen vor oder während des Druckens führen können. Dies gilt auch für entsprechende Mehrschichtenmaterialien gemäß der US-A-3 877 939, die zwischen Trägerblech und lichtempfindlicher, Fotoinitiator enthaltenden Schicht eine Haftschicht aus Polyvinylalkohol und 2-Hydroxyäthylmethacrylat aufweisen. Beschichtet man z. B. Stahlbleche mit pigmentierten Zweikomponenten-Polyurethanlacken gemäß der DE-A-15 97 515 als Grundierschicht (1. Haftschicht) und trägt darauf als Oberlack oder 2. Haftschicht eine Polyvinylalkohol-Hydroxyäthylmethacrylat Schicht gemäß der US-A-3 877 939 auf, so erhält man ein Haftsystem, das sehr gute Haftungen zwischen Fotopolymerschichten auf Polyvinylalkoholbasis und Trägerblechen sowohl im unbelichteten als auch im belichteten Zustand ergibt. Allerdings treten bei Lagerung solcher Platten im unbelichteten Zustand bei Temperaturen über 25° C wiederum Delaminierungserscheinungen auf. So zeigen etwa 2 Wochen bei 30° C im Stapel gelagerte unbelichtete Platten schon deutliche Schichtablösungen ausgehend von den Ecken und Schnittkanten, die bei längerer Lagerung immer schneller zur Plattenmitte hin fortschreiten. Dabei ist meistens eine Spaltung zwischen Trägermaterial und Grundierlack und gleichzeitig – auch in den noch nicht delaminierten Plattenteilen – ein starker Abfall der Haftung bei entsprechender Spaltung festzustellen. Auch hier zeigen sich nach der Klischeeherstellung oder beim Drucken teilweise Reliefablösungen. Dem Fachmann ist ohne weiteres verständlich, daß Produkte mit derartig niedriger Lagerstabilität im Einsatz auf dem Markt laufend zu Reklamationen Anlaß geben.

Aufgabe der Erfindung war es, Haftsysteme für lichtempfindliche Mehrschichtmaterialien zu entwickeln, die mit wäßrigen Lösungsmitteln auswaschbare Fotopolymerschichten sowohl im unbelichteten als auch belichteten Zustand fest mit metallischen Trägerblechen verbinden können und außerdem noch eine gute Haftfestigkeit und keine wesentlichen Schichtablösungen auch nach längerer Lagerung der unbelichteten Platten bei praxisüblichen Temperaturen zwischen 25 und 40° C ergeben.

Überraschenderweise wurde gefunden, daß die vorgenannte Aufgabe gelöst werden kann, wenn zwischen metallischem Trägerblech (T) und der lichtempfindlichen Fotopolymerschicht R (mit der in wäßrigem Lösungsmittel löslichen oder dispergierbaren Monomer-Polymer-Mischung), mindestens eine Haftschicht angeordnet ist, wobei diese Haftschicht bzw. bei mehreren Haftschichten die dem metallischen Trägerblech (T) benachbarte Haftschicht (HG) – auch Grundierlackschicht genannt – ein Pigment und ein Polyurethan-Bindemittel enthält, wobei die Haftschicht (HG) als einziges oder überwiegendes Polyurehtan-Bindemittel ein Umsetzungsprodukt aus

(A1) einem aktive Wasserstoffatome enthaltenden Bindemittel der Formel

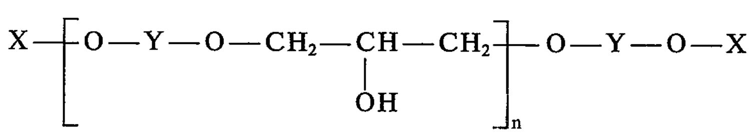

worin

X: 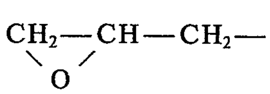 oder 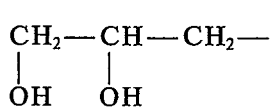

Y: 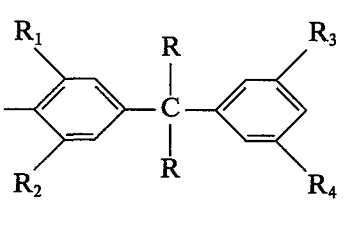

R: H; $CH_3$;
$R_1 - R_4$: H; $CH_3$; $CH_2OH$; Cl; Br
n: eine Zahl von 3 – 150
bedeuten,

(A2) 0 bis 30 Gew.-%, bezogen auf die Summe der Mengen von (A1) und (A2), eines weiteren aktive Wasserstoffatome enthaltenden Oligomeren und/oder Polymeren, und

(A3) 0,5 bis 5 Äquivalenten, bezogen auf 1 Äquivalent der aktiven Wasserstoffatomen von (A1) + (A2), eines Polyisocyanats,

aufweist, sowie

(B) 10 bis 300 Gew.-%, bezogen auf die Komponenten (A1) und (A2) des Polyurethan-Bindemittels, eines Pigments und

(C) 0 bis 50 Gew.-%, bezogen auf die Menge des Pigments (B), eines anorganischen Füllmittels enthält.

Gegenstand der Erfindung sind somit lichtempfindliche Mehrschichtenmaterialien, die eine vorstehend gekennzeichnete Haftschicht als dem Trägerblech (T) benachbarte Schicht aufweisen sowie ein Verfahren zu deren Herstellung.

Gemäß einer speziellen Ausführungsform der Erfindung haben die lichtempfindlichen Aufzeichnungsmaterialien zwischen der dem Trägerblech (T) benachbarten Haftschicht (HG) und der lichtempfindlichen Photopolymerischicht R eine weitere Haftschicht (HO) — als Oberlack für die Schicht (HG) — mit einer guten Haftfestigkeit zur Photopolymerschicht R.

Im Rahmen dieser Erfindung werden mit »Haftschicht (H)« allgemein die Haftschicht bzw. die Haftschichten zwischen dem Trägerblech (T) und der Photopolymerschicht R bezeichnet. Mit »Haftschicht (HG)« ist sowohl bei den Mehrschichtenmaterialien mit nur einer Haftschicht als auch bei den Mehrschichtenmaterialien mit mehreren Haftschichten die auf dem Trägerblech (T) aufgebrachte Haftschicht (Grundierlackschicht) gekennzeichnet. Bei den Mehrschichtenmaterialien mit mehreren Haftschichten zwischen Trägerblech (T) und Photopolymerschicht R sind die weitere(n) Haftschicht(en) zwischen der Haftschicht (HG) und der Photopolymerschicht R mit »Haftschicht (HO)« (Oberlackschicht) bezeichnet.

Metallische Trägerbleche (T) sind bevorzugt Stahl- oder Aluminiumbleche in bekannten Stärken. Auf die Stahlbleche kann eine Zinn-, Chrom- oder Nickelschicht aufgebracht sein. Bevorzugt sind sauer entfettete und anschließend phosphatierte oder chromatisierte Stahlbleche und entfettete und danach chromatisierte Aluminiumbleche.

Als lichtempfindliche Schicht R — auch Fotopolymerschicht R genannt — enthalten die erfindungsgemäßen Mehrschichtmaterialien im wesentlichen eine in wäßrigem Lösungsmittel lösliche oder dispergierbare Monomer-Polymer-Mischung, die neben einem Fotopolymerisationsinitiator fotopolymerisierbare ethylenisch ungesättigte niedermolekulare Verbindungen und mindestens ein Polymer enthält, das mit den ungesättigten niedermolekularen Verbindungen verträglich sein soll. Im Hinblick auf die Verwendung der Mehrschichtenmaterialien als Druckplatten und für die sonstige Herstellung von Reliefformen soll die Schicht R nach einer bildmäßigen Belichtung mit aktinischem Licht mit wäßrigem Lösungsmittel entwickelbar bzw. auswaschbar sein, d. h. die unbelichtete Monomer-Polymer-Mischung muß in wäßrigem Lösungsmittel zumindest dispergierbar, bevorzugt löslich sein. Unter wäßrigem Lösungsmittel werden hierbei Wasser, wäßrige Lösungen sowie Wasser enthaltende Lösungsmittelgemische wie Wasser-Alkohol-Gemische oder wäßrige Lösungen von Alkali- und/oder Erdalkaliverbindungen verstanden.

Besonders bewährt haben sich die erfindungsgemäßen Haftschichten bei Mehrschichtmaterialien, die in der lichtempfindlichen Fotoinitiator enthaltenden Monomer/Polymer-Schicht R als Polymeres Polyvinylalkohol oder wasserdispergierbare oder wasserlösliche Umsetzungsprodukte von Vinylalkohol-Polymeren oder Polymere und Copolymere von Vinylestern aliphatischer Monocarbonsäuren mit 1 bis 4 C-Atomen, wie von Vinylacetat, mit einem Verseifungsgrad von über 50 und bevorzugt 78 bis 90 Mol-% enthalten. Sehr gut sind auch Mehrschichtmaterialien, bei denen als Polymeres der Fotoinitiator enthaltenden Monomer-Polymer-Schicht R alkohollösliche Copolyamide, wie sie z. B. in der FR-A-15 20 856 beschrieben sind, eingesetzt werden und die entsprechenden unbelichteten Polyamid-Monomer-Mischungen mit wäßrigem Alkohol wie Wasser-Äthanol- oder Wasser-Propanol-Mischungen ausgewaschen werden können.

Als weitere polymere Bindemittel für die Schicht R seien in wäßrigem Lösungsmittel oder Lösungsmittelgemischen lösliche oder dispergierbare Polyurethane, Polyätherurethane, Vinylpyrrolidon-Polymere sowie Cellulosederivate genannt, wie sie für die Herstellung von Reliefdruckformen aus fotopolymeren lichtempfindlichen Aufzeichnungsmaterialien beschrieben sind.

Als fotopolymerisierbare ethylenisch ungesättigte Verbindungen für die Schicht R sind vor allem die niedermolekularen Verbindungen mit mindestens einer ethylenisch ungesättigten fotopolymerisierbaren Doppelbindung geeignet, soweit sie mit den jeweils gewählten polymeren Bindemitteln verträgliche Mischungen bilden und einen Siedepunkt von über 100° C bei Atmosphärendruck haben. Bevorzugt sind Monomere mit zwei oder mehr ethylenisch ungesättigten fotopolymerisierbaren Doppelbindungen allein oder deren Mischungen mit Monomeren mit nur einer ethylenisch

ungesättigten fotopolymerisierbaren Doppelbindung.

Die Art der verwendeten Monomeren richtet sich weitgehend nach der Art des mitverwendeten polymeren Bindemittels. Wählt man Mischungen mit Polyamiden als polymere Bindemittel, so eignen sich neben Di- und Polyacrylaten und -methacrylaten, wie sie durch Veresterung von Diolen oder Polyolen mit Acrylsäure oder Methacrylsäure hergestellt werden können, wie Die- und Tri(meth)-acrylate von Ethylenglykol, Diethylenglykol, Triehtylenglykol, Polyethylenglykol mit einem Molekulargewicht bis etwa 500, 1,2-Propandiol, 1,3-Propandiol, Neopentylglykol (2,2-Dimethyl-propandiol), 1,4-Butandiol, 1,1,1-Trimethylolpropan, Glycerin oder Pentaerythrit, besonders solche Monomere, die zusätzlich zu den Doppelbindungen noch Amid- und/oder Urethangruppen enthalten wie Derivate von Acrylamiden, z. B. die Umsetzungsprodukte von 2 Mol N-Hydroxymethyl(meth)-acrylamid mit 1 Mol eines aliphatischen Diols, wie Ethylenglykol, Xylylen-bis-acrylamid oder Alkylen-bis-acrylamide mit 1 bis 8 C-Atomen im Alkylenrest. Für die Herstellung der bevorzugten wäßrig entwickelbaren Platten mit Vinylalkohol-Polymeren als polymerem Bindemittel eignen sich besonders wasserlösliche Monomere, wie z. B. Hydroxyethyl(meth)acrylat, Mono- und Di(meth)acrylate von Polyethylenglykolen mit einem Molekulargewicht von etwa 200 bis 500 sowie Gemische solcher wasserlöslichen Monomeren mit anderen Di- bzw. Poly(meth)acrylaten wie Butandiol-1,4-diacrylat oder 1,1,1-Trimethylolpropan-trimethacrylat. Das Mengenverhältnis in der Mischung von Monomeren und polymerem Bindemittel ist in weitem Umfang variierbar, es beträgt bevorzugt 10 bis 55 und insbesondere 25 bis 50 Gew.-% an Monomeren und 45 bis 90 und insbesondere 50 bis 75 Gew.-% an polymerem Bindemittel, bezogen auf die Summe der Mengen von Monomeren und polymeren Bindemitteln. Die bevorzugten Schichten R sind bei Raumtemperatur fest.

Geeignete Mischungen für die Schicht R können aber auch entsprechend der US-A-3 877 939 aus

a) 10 – 100 Gewichtsteilen teilverseiftem wasserlöslichem Polyvinylacetat eines Polymerisationsgrades von 300 – 2000 und eines Verseifungsgrades von 65 – 99 Mol-%
b) 10 – 300 Gewichtsteilen wenigstens eines ethylenisch ungesättigten fotopolymerisierbaren Monomeren und
c) 0,1 – 15 Gewichtsteilen eines geeigneten Fotoinitiators bestehen.

Die verwendete Menge an Fotoinitiator hängt von seinem Extinktionskoeffizienten und der Schichtdicke der Materialien bei der Härtung ab und beträgt im allgemeinen 0,01 bis 15 Gew.-%, insbesondere etwa 0,01 bis 5 Gew.-% der Gesamtmenge der Schicht R. Als Fotoinitiator sind praktisch alle Verbindungen geeignet, die bei Einwirkung von aktinischem Licht Radikale zu bilden vermögen, die eine Polymerisation auslösen. Als Fotoinitiatoren kommen z. B. in Frage Acyloine und Acyloinether, aromatische Diketone und deren Derivate, mehrkernige Chinone, Acridinderivate, Phenazinderivate. Sehr geeignet sind Benzoin- und $\alpha$-Hydroxymethylbenzoin-alkylether mit 1 bis 8 C-Atomen im Alkylrest, wie Benzoin-isopropylether, $\alpha$-Hydroxymethyl-benzoinmethylether, Benzoin-tetrahydropyranylether oder Benzoinmethylether, Benzilmonoketale wie Benzil-mono-methyl-benzylketal oder Benzil-neopentylketal. Die Mischungen für die Schicht R können auch weitere übliche Zusätze enthalten wie Weichmacher, gesättigte niedermolekulare Verbindungen mit Amidgruppen, Wachse, Aktivatoren, thermische Polymerisationsinhibitoren usw. in den an sich bekannten Mengen.

Die erfindungsgemäße, dem Trägerblech (T) benachbarte 5 bis 100 und insbesondere 10 bis 50 µm starke (Trockenschichtstärke) Haftschicht HG enthält Pigmente und ein Polyurethan-Bindemittel, das überwiegend aus einem höhermolekularen hydroxylgruppenhaltigen Epoxidharz bzw. Phenoxiharz als Reaktionskomponente für die Umsetzung mit dem Polyisocyanat gebildet ist. Für die Umsetzung mit dem Polyisocyanat kommen als Bindemittel (A1) in Frage höhermolekulare, lineare, aromatische Gruppen in der Kette enthaltende Epoxidharze mit Molgewichten im Bereich 1000 – 10 000, vorzugsweise 2500 – 10 000, mit Epoxidäquivalenten von 0,15 – 0,01 vorzugsweise von 0,10 – 0,02, bez. auf 100 g Harz, und ähnlich aufgebaute sogen. Phenoxiharze mit Molgewichten zwischen 10 000 und 50 000, vorzugsweise zwischen 20 000 und 30 000, das sind bevorzugt lineare polymere Glycidylether des Bisphenol-A mit wiederkehrenden Struktureinheiten der Formel

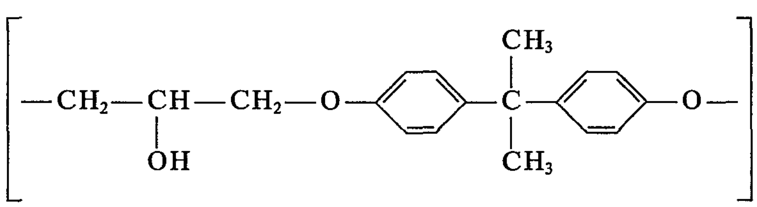

die keine oder nur unwesentliche Mengen an Epoxidgruppen enthalten. Die bevorzugten Bindemittel (A1) enthalten 4 bis 8 und insbesondere 5 bis 7 Gew.-% an OH-Gruppen.

Natürlich können die erfindungsgemäß bevorzugt verwendeten Polyurethan-Bindemittel auch durch Mitverwendung anderer aktive Wasserstoffe und insbesondere Hydroxylgruppen enthaltender Oligomere und/oder Polymere bei der Polyurethanherstellung modifiziert sein, wobei die Menge der

weiteren Oligomeren bzw. Polymeren (A2) 30 und insbesondere 15 Gew.-% der Summe der Mengen an den Komponenten (A1) + (A2) bei der Polyurethanbildung nicht überschreiten soll. Recht geeignet als Komponente (A2) sind z. B. freie Hydroxylgruppen aufweisende Polyester und besonders ein 2 bis 12 und insbesondere 4 bis 10 Gew.-% freie Hydroxylgruppen aufweisender gesättigter Polyester aus Polyolen und Dicarbonsäuren, wobei mindestens 50 Mol-% der Dicarbonsäuren aliphatische Dicarbonsäuren sind. Bevorzugt sind verzweigte Polyester wie sie durch Umsetzung der Dicarbonsäuren oder deren Anhydriden mit molar überschüssigen Mengen an Polyolen hergestellt werden. Als Dicarbonsäuren kommen etwa Adipinsäure und o-Phthalsäure, als Polyole, Trimethylolpropan, Butandiol-1,4, Butandiol-1,3, Propandiol-1,2 und Diethylenglykol in Betracht.

Als Polyisocyanate (A3) zur Polyurethanbildung, d. h. als Härter, kommen sowohl freie als auch sogenannte verkappte Polyisocyanate oder Isocyanat-Abspalter (vgl. z. B. Houben-Weyl, Methoden der organischen Chemie, 4. Auflage, Band XIV/2, Seite 61, G. Thieme Verlag, Stuttgart 1963) in Frage, vorzugsweise Polyisocyanate mit 2 oder mehr aromatisch gebundenen Isocyanatgruppen. Beispiele sind Toluylen-2,4/2,6-diisocyanat (TDI) als freies Isocyanat oder z. B. verkappt mit Phenol; Diphenylmethan-4,4'-diisocyanat (MDI); Naphthylen-1,5-diisocyanat (NDI); 3,3'-Dimethyldiphenyl-4,4'-diisocyanat (TODI); das Umsetzungsprodukt von 3 Molen Toluylendiisocyanat (TDI) mit 1 Mol 1,1,1-Trimethylolpropan als freies Triisocyanat oder etwa verkappt mit Methyläthylketonoxim oder Dibutylmalonat; das Umsetzungsprodukt von 3 Molen TDI mit 1 Mol Thiophosphorsäure; Triphenylmethantriisocyanat; das Dimere von Toluylendiisocyanat; die Oligomeren aus 5 Molen und 7 Molen Toluylendiisocyanat mit jeweils 2 und 3 Isocyanuratringen.

Für die Härtung bzw. Polyurethanbildung werden 0,5 bis 5 und bevorzugt 0,8 bis 2 Äquivalente an Isocyanat pro Äquivalent an Hydroxylgruppe in den Komponenten (A1) und (A2) angewandt, d. h. die 0,5- bis 5fache stöchiometrische Menge.

Die erfindungsgemäßen Haftschichten HG enthalten ferner 10 bis 300 und insbesondere 25 bis 200 Gew.-%, bezogen auf die Menge der Komponenten (A1) und (A2) im Polyurethanbindemittel, eines anorganischen oder organischen Pigments. Als Pigmente eignen sich die üblichen anorganischen und organischen Pigmente wie Titandioxid (Rutil und Anatas), Eisenoxide, Bleichromat, Bariumchromat, Zinkchromat, Zinksulfid, Zinkoxid, basisches Bleicarbonat, Lithopone, Chromoxid, Chromgelb etc.

Für die erfindungsgemäße Grundierlackschicht bzw. Haftschicht HG kommen als weitere Zusatzstoffe Füllmittel, wie etwa Talkum, Bariumsulfat, Calciumcarbonat, übliche Absetzverhinderungsmittel, Mattierungsmittel, z. B. auf Kieselsäurebasis, in Frage. Falls gewünscht, kann bei der Herstellung der Haftschicht HG die Aushärtung und Verankerung des Grundierlacks auch durch Zusatz üblicher Katalysatoren für die Polyisocyanathärtung beschleunigt werden. Solche Beschleuniger sind z. B. tertiäre Amine wie Pyridin, Triethylamin, Endoethylenpiperazin, Triethylendiamin (DABCO), N-Methylmorpholin, N-Ethylmorpholin oder N,N,N',N'-Tetramethyl-1,3-diaminobutan, die in Mengen von 0,005–1 Gew.-%, vorzugsweise 0,01–0,2 Gew.-% zugesetzt werden, sowie Schwermetallsalze wie Zinnoctoat, Zinnstearat; Di-n-butylzinndiacetat; Di-n-butylzinndilaurat und Zinkoctoat, die in Mengen von 0,001–1 Gew.-%, vorzugsweise 0,003–0,1 Gew.-%, zugesetzt werden, wobei sich die Prozentangaben auf den Feststoffgehalt der Haftschicht HG beziehen.

Die Herstellung der Haftschicht HG erfolgt zweckmäßig durch Auftragen eines Grundierlackes, der durch Abmischen bzw. Lösen der Feststoffkomponenten und Reaktanten mit Lösungsmitteln hergestellt ist. Geeignete Lösungsmittel für den Haftschicht-Auftraglack sind aromatische Lösungsmittel wie Toluol, Xylol und Cumol; Glykolester wie Methylglykolacetat, Ethylglykolacetat, Butylglykolacetat; Glykolether wie Diglykoldimethylether; Ester wie Butylacetat, Amylacetat und Butoxyl und Ketone wie Methylethylketon, Methylisobutylketon, Diisobutylketon, Cyclohexanon und Diacetonalkohol. Im allgemeinen enthalten die zum Auftrag fertig abgemischten Grundierlacke soviel solcher Lösungsmittel, daß Verarbeitungsviskositäten von 200 bis 1000 mPas bei Raumtemperatur resultieren.

Zur Herstellung der erfindungsgemäßen Haftschicht HG wird der fertig abgemischte Haftlack mit einem Feststoffgehalt von 20–70, vorzugsweise 40–60 Gew.-%, auf ein entsprechend vorbehandeltes Trägerblech (T) in einer solchen Stärke aufgebracht, daß eine Trockenschichtstärke von 5–100 µm, vorzugsweise 10–50 µm erzielt wird. Die Beschichtung kann mit Hilfe einer der üblichen Techniken wie Streichen, Spritzen, Tauchen, Gießen oder Walzenauftrag erfolgen. Danach wird die Beschichtung bei Temperaturen zwischen 50 und 300°C, vorzugsweise zwischen 100 und 230°C, während eines Zeitraumes von einer Minute bis zu mehreren Stunden, vorzugsweise in 2–60 Minuten getrocknet bzw. eingebrannt. Dies kann z. B. in einem geeigneten Umlufttrockenschrank erfolgen. Vor dem Einbrennen wird zweckmäßigerweise 2–60 Minuten bei Temperaturen zwischen Raumtemperatur und 100°C abgelüftet bzw. vorgetrocknet.

Die erfindungsgemäßen speziellen Haftschichten (HG) auf dem Trägerblech (T) dienen primär der Haftvermittlung zum Trägerblech. In bekannter Weise kann durch eine weitere Haftschicht (HO), d. h. Aufbringen einer weiteren Oberlackschicht, die Haftung zwischen der Haftschicht HG und der lichtempfindlichen Monomer-Polymer-Schicht R verbessert werden. Derartige Mehrschichthaftsysteme sind z. B. für Fotopolymerdruckplatten in der DE-C-1 447 029 sowie den DE-A-22 02 357, 24 14 596, 24 15 728 und 25 05 743 beschrieben.

Die bevorzugten lichtempfindlichen Mehrschichtenmaterialien gemäß der Erfindung weisen eine

solche weitere Haftschicht oder Oberlackschicht (HO) auf. Die Natur der Oberlacke richtet sich hierbei natürlich nach der chemischen Art der lichtempfindlichen reliefbildenden Schicht R, um die gewünschte verbesserte Haftung und Verankerung zur Schicht R zu erzielen.

Als Materialien für die zweiten Haftschichten oder Oberlackschichten HO eignen sich im Falle von lichtempfindlichen Monomer/Polymer-Schichten R auf der Basis von Vinylalkohol-Polymeren z. B. teilverseifte Polyvinylacetate mit einem Verseifungsgrad von 65—99 und bevorzugt von 78—90 Mol-% und einem Polymerisationsgrad von etwa 300—2000, wie sie in der US-A-3 877 939 angegeben sind, sowie die genannten Polyvinylalkohole in Abmischung mit mindestens einem einfach ethylenisch ungesättigten Monomer, wie $\beta$-Hydroxyethylacrylat, $\beta$-Hydroxyethylmethacrylat (entsprechend US-A-3 877 939), Acrylamid, Methacrylamid, N-Methylolacrylamid, N-Methylolmethacrylamid, Di-, Tri- oder Polyethylenglykolmonoacrylaten und/oder -methacrylaten, wobei die Schichten 5—60, vorzugsweise 10—40 Gew.-% an Monomeren enthalten. Geeignet sind auch Haftschichten aus den genannten Komponenten, die außerdem mindestens ein polyfunktionelles ethylenisch ungesättigtes Monomeres enthalten, wie Mono-, Di-, Tri-, oder Polyethylenglykol-diacrylate und/oder -dimethacrylate, Methylenbisacrylamid und/oder -methacrylamid, o-, m- und p-Phenylen- oder Xylylenbisacrylamid oder -methacrylamid, Di-, Tri- und/oder Tetraether aus N-Methylolacrylamid und/oder -methacrylamid und Ethylenglykol, Diethylenglykol, Triethylenglykol, Glycerin, 1,1,1-Trimethylolpropan und/oder Pentaerythrit, Di-, Tri- oder Tetraacrylate und/oder -methacrylate von Glycerin, 1,1,1-Trimethylolpropan oder Pentaerythrit, zweifach ungesättigte Urethanacrylate und -methacrylate wie das Umsetzungsprodukt aus 2 Molen $\beta$-Hydroxyethylmethacrylat und 1 Mol Toluylendiisocyanat oder ungesättigte Epoxyester wie die Umsetzungsprodukte aus 1 Mol Bisphenol-A-diglycidylether und 2 Molen Acrylsäure oder Methacrylsäure. Die Haftschichten enthalten dabei zweckmäßigerweise 4—35, vorzugsweise 7—25 Gew.-% an monofunktionellen Monomeren und 25—1, vorzugsweise 15—3 Gew.-% an bi- und/oder polyfunktionellen Monomeren. Für die Haftschichten HO eignen sich ferner Mischungen aus (a) 75—99, vorzugsweise 85—97 Gew.-% der obengenannten Polyvinylalkohole und (b) 25—1, vorzugsweise 15—3 Gew.-% der obengenannten bi- und/oder polyfunktionellen Monomeren: Mischungen aus (a) 65—99, vorzugsweise 80—95 Gew.-% eines Umsetzungsproduktes eines teilverseiften Polyvinylalkohols (vorzugsweise mit einem Verseifungsgrad von 80—82%) mit (Meth)Acrylsäureanhydrid, wobei der gewichtsmäßige Anteil des (Meth)Acrylsäureanhydrids am Umsetzungsprodukt 5—40, vorzugsweise 5—20 Gew.-% beträgt, und (b) 35—1, vorzugsweise 20—5 Gew.-% eines Umsetzungsproduktes aus 2 Molen einer hydroxylgruppenhaltigen Acryl- oder Methacrylsäureverbindung mit 1 Mol eines bifunktionellen Isocyanats.

Zur Herstellung der Haftschichten HO auf Polyvinylalkohol-Basis werden die vorstehenden Mischungen vorzugsweise als 10—15 gew.-%ige Lösungen (etwa in Ethanol/Wasser 1 : 1) auf das mit der Haftschicht HG beschichtete Trägerblech in einer derartigen Schichtstärke aufgetragen, daß sich eine Trockenfilmdicke von 5—10 µm einstellt. Die Beschichtung erfolgt ebenfalls durch Streichen, Spritzen, Tauchen, Gießen oder Walzenauftrag. Wie bei der Herstellung der ersten Haftschicht HG wird zweckmäßigerweise nach einer Vortrocknung der Lackschicht die Haftschicht HO eingebrannt, was bevorzugt bei 80 bis 160° C während 3 bis 60 Minuten erfolgt.

Im Falle von lichtempfindlichen Monomer/Polymer-Schichten R auf der Basis von Polyamiden, wie sie in der DE-A-22 02 357 angegeben sind, eignen sich als Materialien für die obere Haftschicht HO besonders die dort für die Haftschicht beschriebenen Mischungen von 50—98 Gew.-% eines mit dem Polyamid der Schicht R verträglichen, bei Raumtemperatur festen synthetischen Polyamids mit wiederkehrenden Amidgruppen in der Molekülhauptkette und 2—50 Gew.-% eines härtbaren Phenolharzes mit einem Molekulargewicht unter 10 000 oder einer Mischung eines solchen Phenolharzes mit einer untergeordneten Menge eines härtbaren Aminoplastharzes oder härtbaren Epoxidharzes mit einem Molekulargewicht unter 1000. Zur Herstellung der oberen Haftschicht HO wird bevorzugt die Mischung als 15—25%ige Lösung (etwa in Methanol/Wasser 10 : 1) so aufgetragen, daß die Trockenfilmdicke 10—50 µm beträgt. Die Vortrocknung der Schicht kann wie bei der Herstellung der Grundierhaftschicht HG erfolgen, das Einbrennen wird vorzugsweise bei 120—230° C 3—60 Minuten durchgeführt.

Zur weiteren Herstellung der erfindungsgemäßen lichtempfindlichen Mehrschichtenmaterialien wird auf das mit der erfindungsgemäßen Haftschicht HG und bevorzugt zusätzlich mit einer Oberlackschicht HO versehene Trägerblech (T) die Fotopolymerschicht R mit Vorteil aufkaschiert, wobei für Schichten R auf Basis von Polyvinylalkoholen als polymeren Bindemitteln vorzugsweise Wasser oder Wasser-Ethanol-Mischungen, für Schichten R auf Basis von Polyamiden als polymeren Bindemitteln vorzugsweise Propanol-Wasser-Mischungen als Kaschierlösungsmittel eingesetzt werden. Die erhaltenen fotoempfindlichen Rohplatten bzw. erfindungsgemäßen Mehrschichtenmaterialien zeigen eine ausgezeichnete Haftung der Fotopolymerschicht R auf den Trägerblechen (T) und können unter Lichtausschluß bei praxisüblichen Bedingungen, etwa bei Temperaturen zwischen 0 und 30° C, mindestens 6 Monate gelagert werden, ohne daß eine Schichtablösung vom Trägerblech oder ein wesentliches Absinken der Haftung zu beobachten ist.

Die erfindungsgemäßen Mehrschichtenmaterialien eignen sich besonders zur Herstellung von Reliefformen bzw. Reliefdruckformen. Die Platten lassen sich z. B. in bekannter Weise zu Druckklischees verarbeiten, indem sie nach evtl. nicht-bildmäßiger Vorbelichtung (ohne Vernetzung

der lichtempfindlichen Schicht R) durch ein geeignetes negativ bildmäßig belichtet, durch Auswaschen mit Wasser bzw. geeignetem Lösungsmittelgemisch entwickelt und schließlich nicht-bildmäßig nachbelichtet und getrocknet werden. Zur Vorbelichtung, Bildbelichtung und Nachbelichtung eignen sich die üblichen aktinische Strahlung emittierenden Lichtquellen wie Kohlenbogenlampen, Quecksilberdampflampen, Xenonlampen oder Leuchtstoffröhren. Die Plattenentwicklung kann durch Aufsprühen des Lösungsmittels mit Hilfe eines geeigneten Düsensystems oder durch Ausreiben mit Plüsch oder geeigneten Bürsten, (aufgebracht auf rotierenden und/oder oszillierenden Tellern, Walzen oder Bändern) im Lösungsmittel durchgeführt werden. Die Klischeetrocknung bzw. Nachhärtung erfolgt am zweckmäßigsten durch Aufblasen von Heißluft und/oder Beaufschlagung mit Infrarotstrahlung. Es werden Platten erhalten, deren Reliefs eine ausgezeichnete Haftung auf dem metallischen Träger zeigen. So sind auch beim Drucken hoher Auflagen (etwa bis 1 000 000) z. B. im Rollenrotationsdruck oder im Trockenoffsetdruck keinerlei Ablösungen empfindlicher Reliefteile, wie feiner freistehender Punkte mit 0,3 mm Durchmesser und freistehender Linien von 0,15 mm Dicke zu beobachten. Die benutzten Reliefdruckformen sind darüber hinaus sogar für mehrere Druckauflagen wieder verwendbar, ohne daß sich Reliefteile vom Trägerblech ablösen.

Die in den nachstehenden, die Erfindung erläuternden Beispielen und Vergleichsversuchen angegebenen Teile und Prozente beziehen sich, soweit nicht anders angegeben, auf das Gewicht.

## Beispiel 1

### 1.1 Herstellung der Haftschicht HG

24 Teile eines handelsüblichen Epoxidharzes (hergestellt aus Bisphenol A und Epichlorhydrin) mit einem Epoxidäquivalent von ca. 0,055 (bezogen auf 100 g Harz), einem Molekulargewicht von ca. 2900 und einem OH-Gehalt von 6,1% (Komponente AI) sowie 10 Teile feinteiliges Rutil, 10 Teile Eisenoxidgelb und 6 Teile eines Kupplungsproduktes aus 2 Molen 4-Chlor-3-amino-benzoesäure-[3'-chlor-2'-methylanilid] und 1 Mol 2-Chlor-1,4-bis-acetoacetylaminobenzol als Gelbfarbstoff werden mit 8 Teilen Butylacetat, 26 Teilen Ethylglykolacetat und 16 Teilen Xylol in einer Kugelmühle 2 Tage lang angerieben.

In 100 Teile des resultierenden Stammlacks werden 30,8 Teile (1 Äquivalent) eines handelsüblichen Umsetzungsproduktes aus 1 Mol 1,1,1-Trimethylolpropan und 3 Molen Toluylendiisocyanat als Polyisocyanat (A3) in Form der 67%igen Lösung in Xylol/Ethylglykolacetat (Teilverhältnis 1 : 1) eingemischt.

Der resultierende Lack wird auf 0,24 mm dicke Stahlbleche, die entfettet und anschließend in einer sauren Phosphatlösung vorbehandelt worden sind, schichtförmig aufgegossen. Die Lackschicht wird 1 h bei Raumtemperatur abgelüftet und danach 5 min im Umlufttrockenschrank bei 180° C eingebrannt. Die Trockenfilmstärke der resultierenden Grundierlackschicht (Haftschicht HG) beträgt ca. 18 µm.

### 1.2 Herstellung der Oberlackschicht HO

18 Teile eines teilverseiften Polyvinylacetats (durchschnittlicher Polymerisationsgrad P ca. 500, Verseifungsgrad ca. 80 Mol-%) und 2 Teile β-Hydroxyethylmethacrylat werden in einer Mischung von 85 Teilen Methanol und 85 Teilen Wasser gelöst. Die Lösung wird mit einem Gießer auf die eingebrannte Haftschicht HG schichtförmig aufgegossen, daß eine Trockenfilmdicke von ca. 8 µm resultierte. Die resultierenden doppelbeschichteten Bleche werden nach 1 h Ablüftung bei Raumtemperatur 4 min im Umlufttrockenschrank bei 150° C eingebrannt.

### Auftragen der lichtempfindlichen Schicht R

1300 Teile teilverseiftes Polyvinylacetat (Polymerisationsgrad P ca. 500, Verseifungsgrad ca. 80 Mol-%), 1100 Teile β-Hydroxyethylmethacrylat, 45 Teile Triehtylenglykoldimethacrylat, 40 Teile Benzoinisopropylether und 4 Teile p-Methoxyphenol werden unter starkem Rühren bei 65 bis 70° C in 1700 Teilen vorgelegtem Wasser über einen Zeitraum von 3 bis 4 h gelöst. Anschließend werden bei 70 bis 80° C im Vakuum 900 bis 1000 Teile des Wassers aus der Mischung abgedampft. Die erhaltene Lösung wird bei 70 bis 80° C derartig auf eine 0,15 mm dicke Polyesterfolie gleichmäßig aufgetragen, daß im getrockneten Zustand (nach Lagerung über Nacht bei Raumtemperatur) eine ca. 0,5 mm dicke fotoempfindliche Harzschicht R erhalten wird. Die getrocknete Harzschicht wird zwischen zwei Walzen unter Druck bei gleichzeitigem Aufbringen von wenig Wasser als Kaschierhilfsmittel auf die gemäß Beispiel 1.2 beschichteten Bleche kaschiert, wonach zu Druckplatten verarbeitungsfertige Fotopolymerplatten vorliegen.

### 1.4 Haftungsprüfung der hergestellten lichtempfindlichen Mehrschichtenmaterialien

#### 1.4.1 Ausgangshaftung unbelichtet

24 h nach dem Aufkaschieren der Schicht R werden aus den Mehrschichtplatten mehrere 20 mm breite Streifen geschnitten. An einem Ende derselben werden die Fotopolymerschichten R mechanisch soweit abgelöst, daß sie in die Klaue eines handelsüblichen Zugprüfgeräts (Instrom) eingespannt werden können. Die Fotopolymerschicht R wird dann senkrecht nach oben mit einer Geschwindigkeit von 30 mm/min abgezogen und die dafür erforderliche Kraft in N/20 mm gemessen. Ggf. wird die Spaltungsart festgestellt. Die Prüfergebnisse zeigt Tabelle 1.

#### 1.4.2. Lagerstabilität der Haftung

Gleichzeitig werden mehrere Proben der unbelichteten Platten mit den Abmessungen $100 \times 100$ mm$^2$, in Polyethylenbeuteln verpackt, unter Lichtausschluß 24 h, 3, 4, 5 und 7 Tage bei 50°C gelagert. Danach werden sie auf Raumtemperatur abgekühlt und anschließend auf Haftung im unbelichteten Zustand (Prüfmethode s. o.) und Schichtablösung an Ecken (E) und Schnittkanten (K) visuell geprüft. Die Prüfergebnisse zeigt Tabelle 2.

Es ist klar zu ersehen, daß die erfindungsgemäße Haftschicht sowohl eine hervorragende Ausgangshaftung der unbelichteten Fotopolymerschichten R auf dem Trägerblech als auch eine entsprechende ausgezeichnete Lagerstabilität der Haftung, auch bei erhöhten Lagertemperaturen, ergibt.

## Beispiel 2

Es wird wie in Beispiel 1 verfahren, jedoch werden bei der Herstellung der Haftschicht HG für das Polyurethan-Bindemittel 24 Teile (bezogen auf 100 Teile Stammlack) eines handelsüblichen Epoxidharzes (hergestellt aus Bisphenol-A und Epichlorhydrin; Epoxidäquivalent: ca. 0,03, bezogen auf 100 g Harz; Molekulargewicht 3700 bis 3800; Oh-Gehalt 6,8%) als Komponente A1 und 35 Teile des Polyisocyanats (A3) verwendet.

Die Prüfergebnisse zeigen Tabelle 1 und 2.

## Beispiel 3

Es wird wie in Beispiel 1 verfahren, jedoch werden bei der Herstellung der Haftschicht HG für das Polyurethanbindemittel 24 Teile (bezogen auf 100 Teile Stammlack) eines handelsüblichen Phenoxiharzes (linearer polymerer Glycidylether des Bisphenol-A ohne Epoxidgruppen; Molekulargewicht 20 000 bis 30 000, OH-Gehalt 6,1%) als Komponente A1 und 30,9 Teile des Polyisocyanats (A3) verwendet. Die Prüfergebnisse zeigen Tabelle 1 und 2.

## Beispiel 4

Es wird wie in Beispiel 1 verfahren, jedoch werden bei der Herstellung der Haftschicht HG für das Polyurethanbindemittel 24 Teile (bezogen auf 100 Teile Stammlack) eines handelsüblichen Bisphenol-A-Epichlorhydrin-Epoxidharzes (Epoxidäquivalent ca. 0,04, bezogen auf 100 g Harz; Molekulargewicht ca. 6000; OH-Gehalt 5,2%) als Komponente A1 und 27 Teile des Polyisocyanats (A3) verwendet. Die Prüfergebnisse zeigen Tabelle 1 und 2.

## Beispiel 5

Es wird wie in Beispiel 1 verfahren, jedoch werden bei der Herstellung der Haftschicht HG für das Polyurethanbindemittel 24 Teile eines handelsüblichen Bisphenol-A-Epichlorhydrin-Epoxidharzes (Epoxidäquivalent ca. 0,02 bezogen auf 100 g Harz; Molekulargewicht ca. 9000; OH-Gehalt 5,5%) als Komponente A1 und 28,3 Teile des Polyisocyanats (A3) verwendet. Die Prüfergebnisse zeigen Tabelle 1 und 2.

## Beispiel 6

Es wird wie in Beispiel 5 verfahren, jedoch werden nur 22,7 Teile (=80% der stöchiometrischen Menge) an Polyisocyanat (A3) verwendet. Die Prüfergebnisse zeigen Tabelle 1 und 2.

Beispiel 7

Es wird wie in Beispiel 5 verfahren, jedoch werden 42,5 Teile (=150% der stöchiometrischen Menge) an Polyisocyanat (A3) verwendet. Die Prüfergebnisse zeigen Tabelle 1 und 2.

Beispiel 8

Es wird wie in Beispiel 2 verfahren, jedoch als Trägerblech ein 0,3 mm dickes, in einem Chromatierbad vorbehandeltes Aluminiumblech verwendet. Die Prüfergebnisse zeigt Tabelle 1.

Beispiel 9

Es wird wie in Beispiel 2 verfahren, jedoch als Trägerblech ein mit einer Zinn-Auflage von ca. 12 $g/m^2$ versehenes, 0,24 mm dickes Stahlblech verwendet. Die Prüfergebnisse zeigen Tabelle 1 und 2.

Beispiel 10

Es wird wie in Beispiel 5 verfahren, jedoch werden bei der Herstellung der Haftschicht HG dem Lack vor dem Auftragen 0,25 Teile Dibutylzinn-dilaurat (1%ige Lösung in einer Butylacetat/Ethylglykolacetat/Xylol-Mischung (Teilverhältnis 8 : 26 : 16) zugemischt, die Grundierlackschicht HG 5 min bei 160° C und die Oberlackschicht 4 min bei 130° C eingebrannt. Die Prüfergebnisse zeigen Tabelle 1 und 2.

Beispiel 11

11.1 Herstellung der Haftschicht HG

Die Herstellung erfolgt wie in Beispiel 1.1 angegeben.

11.2 Herstellung der Oberlackschicht HO

100 Teile eines Copolyamids aus etwa gleichen Teilen Hexamethylendiammoniumadipat, 4,4′-Diammonium-dicyclohexylmethanadipat und -Caprolactam mit einem K-Wert (Fikentscher, Cellulosechemie 13 [1932] 58) von 67 sowie 10 Teile eines härtbaren Phenolharzes (hergestellt durch Kondensation von 30 Teilen Phenol und 7,5 Teilen Bisphenol-A mit überschüssigem Formaldehyd bei 100° C in Gegenwart von Dimethylethanolamin) werden in 500 Teilen Methanol und 50 Teilen Wasser bei 50° C gelöst. Mit einem Gießer wird die Lösung so auf das mit der Haftschicht HG versehene Trägerblech schichtförmig aufgetragen, daß eine Trockenfilmdicke von ca. 15 µm resultiert. Nach ca. 30 min Ablüften bei Raumtemperatur wird 5 min im Umlufttrockenschrank bei 180° C eingebrannt.

11.3 Auftragen der lichtempfindlichen Schicht R

1000 Teile des unter 11.2 angegebenen Copolyamids werden zusammen mit 650 Teilen p-Xylylenbisacrylamid, 150 Teilen Triethylenglykoldiacrylat, 10 Teilen Benzoinisopropylether und 1 Teil p-Methoxyphenol in 4000 Teilen Methanol und 100 Teilen Wasser unter Rühren bei 60 bis 65° C gelöst. Die resultierende klare viskose Lösung wird unter Lichtausschluß getrocknet. Das getrocknete, zu Chips zerkleinerte Produkt wird in einer hydraulischen, auf 170 bis 175° C geheizten Presse unter einem Druck von 25 bar zu einer 0,50 mm starken, nach dem Abkühlen klaren transparenten Folie gepreßt. Die entstehende Fotopolymerfolie als Schicht R wird zwischen zwei Walzen unter Druck unter Aufbringen eines Propanol-Wasser-Gemisches als Kaschierhilfsmittel auf die gemäß Beispiel 11.2 beschichteten Trägerbleche kaschiert.

Die Ergebnisse der Haftprüfung zeigen Tabelle 1 und 2.

Vergleichsversuch 1

Die Herstellung der Haftschicht HG erfolgt durch schichtförmiges Aufgießen eines Lackes aus 15 Teilen eines teilverseiften Polyvinylacetats (durchschnittlicher Polymerisationsgrad P ca. 500, Verseifungsgrad ca. 80 Mol-%), 20 Teilen $\beta$-Hydroxyethyl-methacrylat, 0,2 Teilen Azo-bis-isobutyronitril (AIBN), gelöst in 57 Teilen Wasser, 4 Teilen Methanol und 4 Teilen Aceton (zur Vorlösung des AIBN)

auf ein entfettetes und mit einer sauren Phosphatlösung vorbehandeltes 0,24 mm dickes Stahlblech. Die beschichteten Bleche werden 1 h bei Raumtemperatur abgelüftet und 5 min im Umlufttrockenschrank bei ca. 180° C eingebrannt. Die Schichtstärke der Haftschicht HG beträgt ca. 10 µm.

Auf die mit der Haftschicht HG versehenen Trägerbleche werden wie in Beispiel 1.3 angegeben die lichtempfindlichen Schichten R aufgebracht. Die Ergebnisse der Haftprüfung der resultierenden Mehrschichtmaterialien zeigt Tabelle 1.

Vergleichsversuch 2

Es wird wie in Beispiel 1 verfahren, jedoch werden bei der Herstellung der Haftschicht HG für das Polyurethan-Bindemittel 24 Teile eines handelsüblichen Polyesters aus 2,5 Molen Adipinsäure, 0,5 Mol Phthalsäure und 4 Molen 1,1,1-Trimethylolpropan als Komponente A1 und 45,6 Teile (1Äquivalent) des Polyisocyanats (A3) sowie statt des Rutil-Eisenoxidgelb-Gemisches 20 Teile Rutil verwendet. Die Prüfergebnisse der resultierenden Mehrschichtmaterialien zeigen Tabelle 1 und 2.

Vergleichsversuch 3

Es wird wie in Beispiel 1 verfahren, jedoch werden bei der Herstellung der Haftschicht HG für das Polyurethan-Bindemittel 24 Teile eines handelsüblichen Epoxidharzes (aus Bisphenol A und Epichlorhydrin) mit einem Epoxidäquivalent von 0,2 (bezogen auf 100 g Harz), einem Molekulargewicht von ca. 900 und einem OH-Gehalt von 5,0% als Komponente A1 und 24,7 Teile (1 Äquivalent) des Polyisocyanats (A3) verwendet. Die Prüfergebnisse der Mehrschichtmaterialien zeigen Tabelle 1 und 2.

Vergleichsversuch 4

Es wird wie in Beispiel 1 verfahren, jedoch werden bei der Herstellung der Haftschicht HG für das Polyurethan-Bindemittel eine Mischung von 12 Teilen des im Vergleichsversuch 2 angegebenen Polyesters und 12 Teilen eines handelsüblichen Bisphenol-A-Epichlorhydrin-Epoxidharzes (Epoxidäquivalent ca. 0,03, bezogen auf 100 g Harz; Molekulargewicht 3700 bis 3800) als Komponente A1 und 40,3 Teile (stöchiometrische Menge) des Polyisocyanats (A3) verwendet. Die Ergebnisse der Haftprüfung der resultierenden Mehrschichtmaterialien zeigen Tabellen 1 und 2.

Tabelle 1

Ergebnisse der Haftungsprüfung der lichtempfindlichen Mehrschichtenplatten:

Ausgangshaftung unbelichtet und Art der Spaltung (HG/T = Spaltung zwischen Haftschicht HG und Trägerblech)

| | |
|---|---|
| Beispiel 1 – 11 | nicht ablösbar |
| Vergleichsversuch 1 | 10 N/20 mm; HG/T |
| Vergleichsversuch 2 | nicht ablösbar |
| Vergleichsversuch 3 | 14 N/20 mm, HG/T |
| Vergleichsversuch 4 | nicht ablösbar |

Tabelle 2

Ergebnisse der Haftungsprüfung der lichtempfindlichen Mehrschichtenplatten:

Lagerstabilität der Haftung (unbelichtet)
Schichtablösung = Ablösung um 1 mm an 50% der Ecken (E) bzw. Kanten (K)
HG/T = Spaltung zwischen Haftschicht HG und Trägerblech

| Beispiel (B) Nr. bzw. Vergleichsversuch (V) Nr. | Schichtablösung Beginn | | Spaltungsart | Haftungsabfall auf weniger als 20 N/20 mm Zeit | Spaltungsart |
|---|---|---|---|---|---|
| B 1 | E : 8 h–1 d | K : 1–2 d | HG/T | 3 d | HG/T |
| B 2 | E : 4 d | K : 7 d | HG/T | >7 d | |
| B 3 | E : 3 d | K : 7 d | HG/T | 7 d | HG/T |
| B 4 | E : 4 d | K : 7 d | HG/T | >7 d | |
| B 5 | E : 7 d | K : >7 d | HG/T | >7 d | |
| B 6 | E : 3 d | K : 5 d | HG/T | 7 d | HG/T |
| B 7 | E : >7 d | K : >7 d | | >7 d | |
| B 9 | E : 3 d | K : 7 d | HG/T | 5 d | HG/T |
| B 10 | E : 7 d | K : >7 d | HG/T | >7 d | |
| B 11 | E : >7 d | K : >7 d | | >7 d | |
| V 2 | E : 3 h | K : 8 h | HG/T | 3 h | HG/T |
| V 3 | E : <3 h | K : 3 h | HG/T | | |
| V 4 | E : 8 h | K : 1 d | HG/T | 8 h–1 d | HG/T |

**Patentansprüche**

1. Lichtempfindliches Mehrschichtenmaterial, das

(a) zwischen einem metallischen Trägerblech (T) und
(b) einer lichtempfindlichen Schicht R einer Fotoinitiator enthaltenden in wäßrigem Lösungsmittel löslichen oder dispergierbaren Mischung von mindestens einer fotopolymerisierbaren ethylenisch ungesättigten niedermolekularen Verbindung und mindestens einem damit verträglichen Polymeren
(c) mindestens eine haftvermittelnde Schicht aufweist, wobei diese, bei mehreren Haftschichten die dem metallischen Trägerblech (T) benachbarte, 5 bis 100 µm starke Haftschicht (HG) als Bindemittel ein Polyurethan sowie Pigment enthält,

dadurch gekennzeichnet, daß die Haftschicht HG als einziges oder überwiegendes Polyurethan-Bindemittel ein Umsetzungsprodukt (A) aus

(A1) einem aktive Wasserstoffatome enthaltenden Bindemittel der Formel

$$X-\left[O-Y-O-CH_2-\underset{\displaystyle OH}{\underset{|}{CH}}-CH_2\right]_n-O-Y-O-X$$

worin

X: 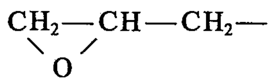 oder 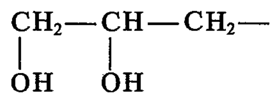

Y: 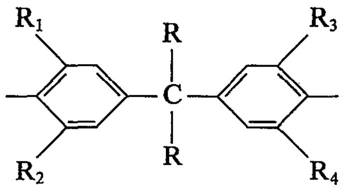

R: H; $CH_3$;
$R_1-R_4$: H; $CH_3$; $CH_2OH$; Cl; Br
n: eine Zahl von 3—150
bedeuten,

(A2) 0 bis 30 Gew.-%, bezogen auf die Summe der Mengen von (A1) und (A2), eines weiteren aktive Wasserstoffatome enthaltenden Oligomeren und/oder Polymeren, und

(A3) 0,5 bis 5 Äquivalenten, bezogen auf 1 Äquivalent der aktiven Wasserstoffatome von (A1) + (A2), eines Polyisocyanats

aufweist, sowie

(B) 10 bis 300 Gew.-%, bezogen auf die Komponenten (A1) und (A2) des Polyurethan-Bindemittels, eines Pigments und

(C) 0 bis 50 Gew.-%, bezogen auf die Menge des Pigments (B), eines anorganischen Füllmittels enthält.

2. Lichtempfindliches Mehrschichtenmaterial gemäß Anspruch 1, dadurch gekennzeichnet, daß das Umsetzungsprodukt (A) durch Reaktion eines Polyisocyanats mit einem löslichen Epoxidharz mit einem Molekulargewicht von 2500 bis 10 000, einem Epoxidäquivalent von 0,1 bis 0,02 (bezogen auf 100 g Harz) und einem Hydroxylgruppengehalt von 4 bis 8 Gew.-% als Komponente (A1) gebildet ist.

3. Lichtempfindliches Mehrschichtenmaterial gemäß Anspruch 1, dadurch gekennzeichnet, daß das Umsetzungsprodukt (A) durch Reaktion eines Polyisocyanats mit einem linearen polymeren Glycidylether des Bisphenol-A mit wiederkehrenden Struktureinheiten der Formel

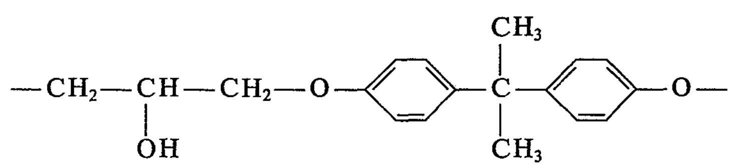

mit einem Molekulargewicht von 10 000 bis 50 000 als Komponente (A1) gebildet ist.

4. Lichtempfindliches Mehrschichtenmaterial gemäß einem der Ansprüche 1 bis 3, dadurch gekennzeichnet, daß das Umsetzungsprodukt (A) durch Reaktion eines Polyisocyanats (A3) mit einem Bindemittel (A1) und einem freie Hydroxylgruppen aufweisenden Polyester als Komponente (A2) gebildet ist.

5. Lichtempfindliches Mehrschichtenmaterial gemäß Anspruch 4, dadurch gekennzeichnet, daß die Komponente (A2) einen 2 bis 12 Gew.-% freie Hydroxylgruppen aufweisender gesättigter Polyester aus Polyolen und Dicarbonsäuren, wovon mindestens 50 Mol-% aliphatische Dicarbonsäuren sind, darstellt.

6. Verfahren zur Herstellung lichtempfindlicher Mehrschichtmaterialien durch

(a) schichtförmiges Auftragen eines pigmentierten Haftlacks, der hydroxylgruppenhaltige Verbindungen und Polyisocyanate als Bindemittelkomponenten enthält, auf ein metallisches Trägerblech (T) und Einbrennen des Haftlacks unter Bildung einer 5 bis 100 µm starken Haftschicht (HG),

(b) gegebenenfalls Aufbringen einer weiteren Haftschicht (HO) mit verbesserter Haftung zur lichtempfindlichen Schicht R, sowie

(c) Aufbringen einer lichtempfindlichen Schicht R mit einer Fotoinitiator enthaltenden Mischung von mindestens einer fotopolymerisierbaren ethylenisch ungesättigten Verbindung mit mindestens einem damit verträglichen Polymeren,

dadurch gekennzeichnet, daß der Haftlack für die Haftschicht HG als Polyurethan bildende Bindemittelkomponenten

(A1) ein aktive Wasserstoffatome enthaltendes Bindemittel der Formel

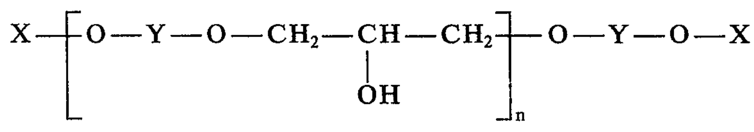

worin

X: 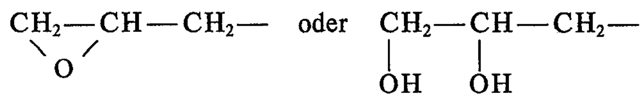

Y: 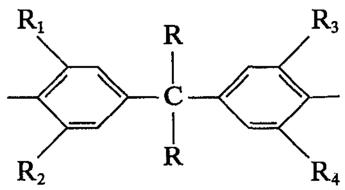

R: H; $CH_3$;
$R_1-R_4$: H; $CH_3$; $CH_2OH$; Cl; Br
n: 3–150 bedeuten,

(A2) 0 bis 30 Gew.-% bezogen auf die Summe der Mengen von (A1) und (A2) eines weiteren aktive Wasserstoffatome enthaltenden Oligomeren und/oder Polymeren, und

(A3) 0,5 bis 5 Äquivalente, bezogen auf 1 Äquivalent der aktiven Wasserstoffatome von (A1)+(A2), eines Polyisocyanats aufweist sowie

(B) 10 bis 300 Gew.-%, bezogen auf die Komponenten (A1) und (A2), eines Pigments und

(C) 0 bis 50 Gew.-%, bezogen auf die Menge des Pigments (B), eines anorganischen Füllmittels enthält.

**Claims**

1. A photosensitive multi-layer material having

(a) between a metal base B and

(b) a photosensitive layer R of a mixture which is soluble or dispersible in an aqueous solvent and contains at least one photopolymerizable, ethylenically unsaturated, low molecular weight compound, at least one polymer compatible therewith, and a photoinitiator,

(c) at least one adhesive layer, this adhesive layer AL being from 5 to 100 µm thick and adjacent to the metal base B if several adhesive layers are present, and containing a polyurethane as binder, and pigment,

wherein the adhesive layer contains, as aole or main polyurethane binder, a reaction product (A) derived from

(A1) a binder, containing reactive hydrogen atoms, of the formula

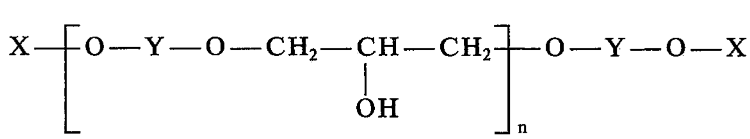

where

X is 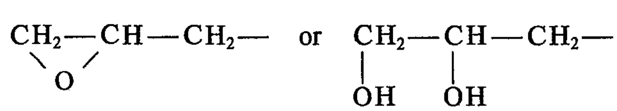

Y is 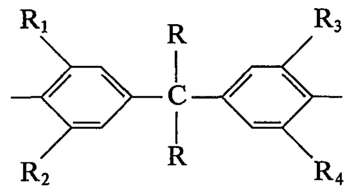

R is H or $CH_3$,
$R_1$, $R_2$, $R_3$ and $R_4$ are H, $CH_3$, $CH_2OH$, Cl or Br and
n is a number from 3 to 150,

(A2) from 0 to 30% by weight, based on the sum of the amounts of (A1) and (A2), of an additional oligomer and/or polymer, containing reactive hydrogen atoms, and

(A3) from 0.5 to 5 equivalents, per equivalent of reactive hydrogen atoms of (A1)+(A2), of a polyisocyanate,

(B) from 10 to 300% by weight, based on components (A1) and (A2) of the polyurethane binder, of a pigment and

(C) from 0 to 50% by weight, based on the amount of pigment (B), of an inorganic filler.

2. A photosensitive multi-layer material as claimed in claim 1, wherein the reaction product (A) is formed by reacting a polyisocyanate with a soluble epoxy resin having a molecular weight of 2,500 to 10,000, an epoxide equivalent of from 0.1 to 0.02 (based on 100 g of resin) and a hydroxyl content of from 4 to 8% by weight, this resin constituting component (A1).

3. A photosensitive multi-layer material as claimed in claim 1, wherein the reaction product (A) is formed by reacting a polyisocyanate with a linear polymeric glycidyl ether of bisphenol A, which contains recurring structural units of the formula

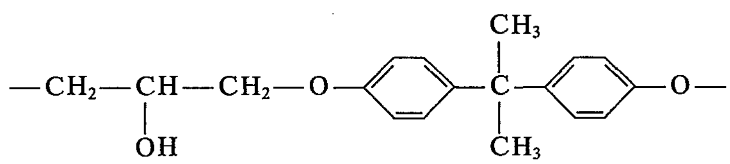

and has a molecular weight of from 10,000 to 50,000, this polymeric ether constituting component (A1).

4. A photosensitive multi-layer material as claimed in any of claims 1 to 3, wherein the reaction product (A) is formed by reacting a polyisocyanate with a binder (A1) and with a polyester, having free hydroxyl groups, as component (A2).

5. A photosensitive multi-layer material as claimed in claim 4, wherein component (A2) is a saturated polyester containing from 2 to 12% by weight of free hydroxyl groups and prepared from polyols and dicarboxylic acids, of which not less than 50 mole% are aliphatic dicarboxylic acids.

6. A process for the preparation of a photosensitive multi-layer material by

(a) applying a layer of a pigmented solution, containing hydroxyl-containing compounds and polyisocyanates as binder components, to a metal base B, and baking the applied layer of solution to give a 5 to 100 μm thick adhesive layer AL,

(b) optionally applying a further adhesive layer ALU exhibiting good adhesion to the photosensitive layer R, and

(c) applying a photosensitive layer R comprising a mixture which contains at least one photopolymerizable, ethylenically unsaturated compound, at least one polymer compatible therewith, and a photoinitiator,

wherin the solution forming the adhesive layer AL contains as the polyurethane-forming components

(A1) a binder, containing reactive hydrogen atoms, of the formula

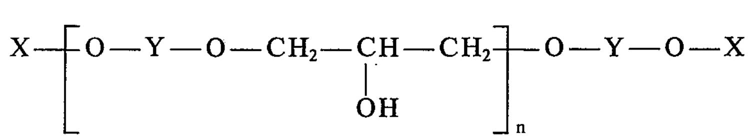

where

X is 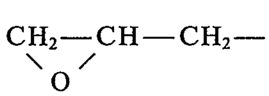 or 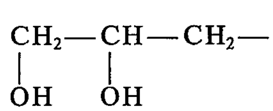

Y is 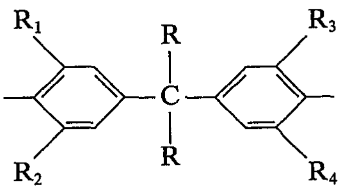

R is H or $CH_3$,
$R_1$, $R_2$, $R_3$ and $R_4$ are H, $CH_3$, $CH_2OH$, Cl or Br and
n is a number from 3 to 150,

(A2) from 0 to 30% by weight, based on the sum of the amounts of (A1) and (A2), of an additional oligomer and/or polymer, containing reactive hydrogen atoms, and
(A3) from 0.5 to 5 equivalents, per equivalent of reactive hydrogen atoms of (A1)+(A2), of a polyisocyanate,
(B) from 10 to 300% by weight, based on components (A1) and (A2), of a pigment and
(C) from 0 to 50% by weight, based on the amount of pigment (B), of an inorganic filler.

**Revendications**

1. Matériau multicouche photosensible qui contient

a) entre une plaque support métallique (T) et
b) une couche photosensible (R), un mélange, soluble ou dispersable dans un solvant aqueux et contenant un photoinitiateur, d'au moins un composé photopolymérisable, à insaturation éthylénique et de faible poids moléculaire, et au moins un polymère compatible avec lui
c) au moins une couche assurant l'adhérence, celle-ci, ou bien, dans le cas de plusieurs couches d'adhérence, la couche d'adhérence (HG), de 5 à 100 μm d'épaisseur, contiguë à la plaque support métallique (T), contenant, comme liant, un polyuréthane ainsi qu'un pigment, caractérisé par le fait que la couche d'adhérence (HG) contient comme unique, ou

principal, liant polyuéthane un produit de réaction (A) de:

(A1) un liant, contenant un atome d'hydrogène actif, de formule:

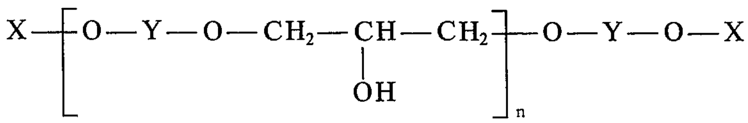

dans laquelle

X représente 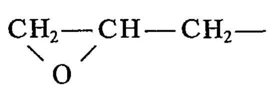 ou 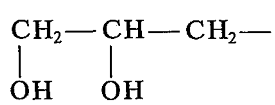

Y représente 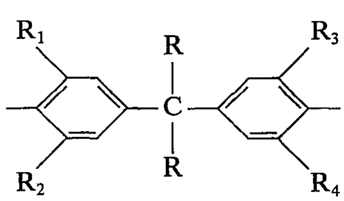

R représente: H; $CH_3$;
$R_1 - R_4$: H; $CH_3$; $CH_2OH$; Cl; Br
n représente un nombre de 3 à 150

(A2) 0 à 30% en poids, rapportés à la somme des quantités de (A1) et (A2), d'un oligomère et/ou polymère contenant un autre hydrogène actif, et
(A3) 0,5 à 5 équivalents, rapportés à 1 équivalent de l'atome d'hydrogène actif de (A1)+(A2), d'un polyisocyanate

ainsi que

(B) 10 à 300% en poids, rapportés aux composants (A1) et (A2) du liant polyuréthane, d'un pigment et
(C) 0 à 50% en poids, rapportés à la quantité du pigment (B), d'une charge inorganique.

2. Matériau multicouche photosensible selon la revendication 1, caractérisé par le fait que le produit de réaction (A) est formé par réaction d'un polyisocyanate avec, comme composant (A1), une résine époxy soluble, d'un poids moléculaire de 2500 à 10 000, d'un équivalent époxy de 0,1 à 0,2 (rapporté à 100 g de résine) et d'une teneur en groupes hydroxyle de 4 à 8% en poids.

3. Matériau multicouche photosensible selon la revendication 1, caractérisé par le fait que le produit de réaction (A) est formé par réaction d'un polyisocyanate avec, comme composant (A1), un éther glycidylique, linéaire, polymère du bis-phénol-A à motifs structurels répétitifs, de formule

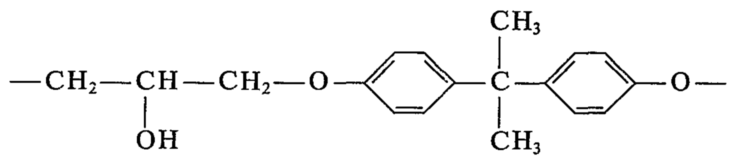

dún poids moléculaire de 10 000 à 50 000.

4. Matériau multicouche photosensible selon l'une des revendications 1 à 3, caractérisé par le fait que le produit de réaction (A) est formé par réaction d'un polyisocyanate (A3) avec un liant (A1) et, comme composant (A2), un polyester possèdant des groupes hydroxyle.

5. Matériau multicouche photosensible selon la revendication 4, caractérisé par le fait que le composant (A2) représente un polyester saturé, possédant 2 à 12% en poids de groupes hydroxyle libres, de polyols et d'acides dicarboxyliques, dont au moins 50% (moles) sont des acides dicarboxyliques aliphatiques.

6. Procédé de préparation de matériaux multicouches photosensibles par

a) application, sous forme de couche, d'une laque d'adhérence pigmentée, qui contient, comme composants de liant, des composés à groupes hydroxyle et des polyisocyanates, sur une plaque support (T) métallique, et cuisson de la laque d'adhérence avec formation d'une couche d'adhérence (HG) d'une épaisseur de 5 à 100 μm,
b) application éventuelle d'une autre couche d'adhérence (HO), de meilleure adhérence, à la couche photosensible (R) ainsi que
c) application d'une couche photosensible (R) avec un mélange, contenant un photoinitiateur, d'au moins un composé photopolymérisable à insaturation éthylénique avec au moins un polymère compatible avec lui,

caractérisé par le fait que la laque d'adhérence pour la couche d'adhérence (HG) contient, comme composants de liant formant polyuréthane,

(A1) un liant, contenant un atome d'hydrogène actif, de formule

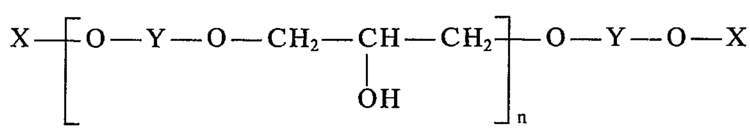

dans laquelle

X représente 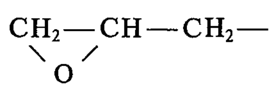 ou 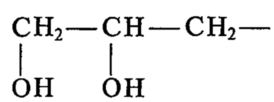

Y représente 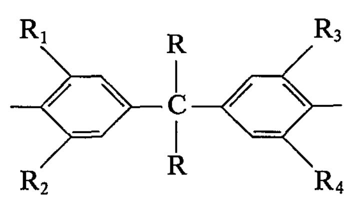

R représente H; $CH_3$;
$R_1 - R_4$: H; $CH_3$; $CH_2OH$; Cl; Br
n représente un nombre de 3 à 150

(A2) 0 à 30% en poids, rapportés à la somme des quantités de (A1) et (A2) d'un oligomère et/ou polymère contenant un autre hydrogène actif, et

(A3) 0,5 à 5 équivalents, rapportés à 1 équivalent de l'atome d'hydrogène actif de (A1)+(A2), d'un polyisocyanate

ainse que

(B) 10 à 300% en poids, rapportés aux composants (A1) et (A2) du liant polyuréthane, d'un pigment et

(C) 0 à 50% en poids, rapportés à la quantité du pigment (B), d'une charge inorganique.